(19) Europäisches Patentamt
European Patent Office
Office européen des brevets

(11) **EP 3 435 529 B1**

(12) **EUROPÄISCHE PATENTSCHRIFT**

(45) Veröffentlichungstag und Bekanntmachung des Hinweises auf die Patenterteilung:
**22.11.2023 Patentblatt 2023/47**

(21) Anmeldenummer: **18185434.0**

(22) Anmeldetag: **25.07.2018**

(51) Internationale Patentklassifikation (IPC):
**H02M 1/14** *(2006.01)* **H02J 1/02** *(2006.01)*

(52) Gemeinsame Patentklassifikation (CPC):
**H02M 1/143; H02J 1/02**

(54) **ENTSTÖRVORRICHTUNG FÜR EINEN GLEICHSTROMKREIS**

CIRCUIT FOR DISTORTION CANCELLATION IN A DC CIRCUIT

DISPOSITIF DE SUPPRESSION D'INTERFÉRENCE POUR UN CIRCUIT À COURANT CONTINU

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **28.07.2017 DE 102017117183**

(43) Veröffentlichungstag der Anmeldung:
**30.01.2019 Patentblatt 2019/05**

(73) Patentinhaber: **BRUSA Technology AG
9470 Buchs (CH)**

(72) Erfinder: **KRAUSE, Axel
9650 Nesslau (CH)**

(74) Vertreter: **Rösler Rasch van der Heide & Partner
Bodenseestraße 18
81241 München (DE)**

(56) Entgegenhaltungen:
WO-A1-2013/004019          DE-A1- 2 160 925
DE-A1-102014 200 018     DE-B- 1 203 839
DE-C- 433 673                    US-A1- 2005 141 248

**EP 3 435 529 B1**

**Beschreibung**

Feld der Erfindung

Die vorliegende Erfindung betrifft das technische Gebiet von Gleichstromnetzwerken. Insbesondere betrifft die vorliegende Erfindung eine Entstörvorrichtung für einen Gleichstromkreis, eine Fahrzeugkomponente, einen Hochspannungs-Zwischenkreis und ein Fahrzeug.

Hintergrund der Erfindung

Ein Stromkreis dient dazu, verschiedene Komponenten mit elektrischer Energie zu versorgen. An einem Stromkreis kann eine einzige Komponente betrieben werden; es können aber auch, wie es oft beispielsweise in einem Elektro- oder Hybridfahrzeug der Fall ist, eine Vielzahl von Komponenten betrieben werden. Komponenten, die an einem Gleichstromkreis betrieben werden, sind jedoch anfällig für Störungen, insbesondere für Wechselspannungen, die auf dem Gleichstromkreis aus den unterschiedlichen Gründen entstehen oder von außen auf den Gleichstromkreis eingekoppelt werden und sich auf dem Gleichstromkreis ausbreiten.

Die Störanfälligkeit einer Komponente kann davon verursacht werden, dass Filterkomponenten, die eigentlich dafür vorgesehen sind, Störungen zu unterdrücken, welche von der Komponente erzeugt werden, beim Auftreten Störungen auf dem Gleichstromkreis, insbesondere beim Auftreten einer Wechselspannung mit einer bestimmten Frequenz, so angeregt werden, dass sie zu einer Zerstörung der Komponente oder einzelner Bauteile der Komponente führen.

Die Druckschrift DD 208 019 betrifft die Verringerung der Strombelastung von zusätzlichen Drosseln, die in einem Gleichstromsystem zur Strombegrenzung im Havariefall vorhanden sind und über die auch der volle Laststrom fließt, für einen Spannungswechselrichter zur Speisung von Drehstrommmaschinen.

Die Druckschrift DE 21 60 925 A1 beschreibt ein Verfahren und Filter zur Beseitigung der Brummkomponente eines Gleichstroms.

Die Druckschrift US 2005/141248 A1 betrifft ein Leistungselektroniksystem zum Konditionieren einer Leistung aus einer Brennstoffzelle mit einem Boost-Wandler, zum Erhöhen einer Spannung einer Gleichstromausgangsspannung der Brennstoffzelle und zum Entfernen eines Rippels durch gegenseitige Induktivitäten, mit einem Hochfrequenzwandler und mit einem AC-AC-Wandler.

Gegenüber der US 2005/141248 A1 besteht daher die Aufgabe, eine Alternative zur dort offenbarten passiven und transformatorisch und konduktiv gekoppelten resonanten Entstörschaltung zu erhalten.

Zusammenfassung der Erfindung

Dementsprechend wird eine Entstörvorrichtung für einen Gleichstromkreis, eine Fahrzeugkomponente, ein Hochspannungs-Zwischenkreis und ein Fahrzeug angegeben.

Der Gegenstand der Erfindung wird von den Merkmalen des unabhängigen Patentanspruchs 1 angegeben.

Ausführungsbeispiele und weitere Aspekte der Erfindung werden von den abhängigen Ansprüchen und der folgenden Beschreibung angegeben.

Gemäß einem Aspekt der Erfindung wird eine Entstörvorrichtung für einen Gleichstromkreis angegeben. Der Gleichstromkreis weist zumindest zwei Leiter auf. Die Entstörvorrichtung weist einen ersten Anschluss auf, der zum Verbinden der Entstörvorrichtung mit einem ersten Leiter des Gleichstromkreises dient und einen zweiten Anschluss, der zum Verbinden der Entstörvorrichtung mit einem zweiten Leiter des Gleichstromkreises dient. Außerdem weist die Entstörvorrichtung einen Sensor auf. Der Sensor ist im Wesentlichen berührungslos mit dem Gleichstromkreis koppelbar. In einem Beispiel mag die Eigenschaft "berührungslos" eine galvanische Kopplung bezeichnen, da durchaus eine mechanische Berührung über einen Wickelkern eines Transformators möglich ist. In einem anderen Beispiel mag eine im Wesentlichen vollkommene Luftkopplung mit dem Gleichstromkreis herstellbar sein, so dass im Wesentlichen - abgesehen von Verbindungen über einen gemeinsamen Anschluss - keine elektrische Kopplung und auch keine mechanische Kopplung zwischen dem Sensor und dem Gleichstromkreis besteht. Insbesondere existiert solch eine Verbindung nicht für die Übertragung einer Messgröße, wie den im Gleichstromkreis fließenden Wechselstrom. Oder in anderen Worten ausgedrückt mag ein im Gleichstromkreis fließender Wechselstrom von der Koppelung im Wesentlichen berührungslos übertragen werden.

Der Sensor ist auch dazu eingerichtet, ein Übersteigen eines vorgebbaren Grenzwertes einer überlagerten Wechselspannung in dem ersten Leiter des Gleichstromkreises zu erkennen und durch Einprägen eines Stromes in den ersten Anschluss die Wechselspannung im ersten Leiter des Gleichstromkreises im Wesentlichen auf den vorgebbaren Grenzwert zu verringern und/oder unter dem Grenzwert zu lassen. Der Strom wird induktiv aufgenommen aber konduktiv über Dioden in den Gleichstromkreis eingeprägt.

Gemäß einem weiteren Aspekt der vorliegenden Erfindung wird eine Komponente, insbesondere eine Fahrzeugkomponente angegeben. Bei der Komponente kann es sich beispielsweise um einen Antriebs-Umrichter, einen Bordnetzwandler, ein Ladegerät, einen Klimakompressor oder einen Umrichter handeln. Die Komponente weist einen Gleichstromkreis mit einem ersten Leiter, einem zweiten Leiter und einem Zwischenkreis-Filter auf. Außerdem ist in oder an der Komponente die erfindungsgemäße Entstörvorrichtung vorhanden, wobei der erste Anschluss der Entstörvorrichtung mit dem ersten Leiter verbunden ist, der zweite Anschluss der Entstörvorrichtung mit dem zweiten Leiter verbunden ist und der Sensor im Wesentlichen berührungslos mit dem Zwischenkreis-Filter gekoppelt ist. Ferner ist der Gleichstromkreis zum Anschließen an einen Hochspannungs-Zwischenkreis eingerichtet.

Gemäß noch einem Aspekt der Erfindung wird ein Hochspannungs-Zwischenkreis für ein Fahrzeug angegeben. Dieser Hochspannungs-Zwischenkreis weist eine Versorgungsbatterie, eine erste Komponente, welche mit einer Arbeitsfrequenz betrieben wird und zumindest eine zweite Komponente auf. Außerdem weist der Hochspannungs-Zwischenkreis zumindest eine erfindungsgemäße Entstörvorrichtung auf. Die Versorgungsbatterie, die erste Komponente und die zweite Komponente sind jeweils mit einem ersten Leiter und einem zweiten Leiter des Hochspannungs-Zwischenkreises verbunden.

Der erste Leiter der zumindest einen zweiten Komponente ist mit dem ersten Anschluss der Entstörvorrichtung verbunden und der zweite Leiter der zumindest einen zweiten Komponente ist mit dem zweiten Anschluss der Entstörvorrichtung verbunden. Darüber hinaus ist der Sensor der Entstörvorrichtung berührungslos mit dem zu der zumindest zweiten Komponente gehörenden Teil des ersten Leiters und/oder des zweiten Leiters gekoppelt.

Die Entstörvorrichtung kann auch als resonanter Leistungsregenierungsschaltkreis (resonant power regeneration circuit) bezeichnet werden. In diesem Text mögen die Begriffe "Kondensator" und "Kapazität" sowie "Spule" oder "Drossel" und "Induktivität" gleichbedeutend verwendet werden.

Werden Komponenten von einem OEM (Original Equipment Manufacturer) bei einem Zulieferer bestellt, so legt der OEM eine maximale zulässige Amplitude fest, die innerhalb eines ebenfalls vorgegebenen Frequenzbereichs nicht überschritten werden darf. Würde diese Amplitude überschritten, könnte die Komponente beschädigt oder zerstört werden. Um eine Störung ausgehend von der Komponente auf andere Komponenten, die an dem gleichen Stromkreis angeschlossen sind, zu verhindern, mag die Komponente selbst ein Zwischenkreisfilter aufweisen, wobei das Filter zumindest einen Zwischenkreiskondensator und zumindest eine Zwischenkreisspule oder eine Zwischenkreisdrossel enthält. Dieses Zwischenkreisfilter mag als ein Tiefpassfilter ausgebildet sein. Dieses Tiefpassfilter mag eine Resonanzfrequenz aufweisen, die weit unterhalb der Taktfrequenz liegt, mit der die jeweilige Komponente arbeitet, z:B. ein Antriebs-Umrichter, ein Bordnetzwandler, ein Ladegerät oder Klimakompressor-Umrichter. Durch die Auslegung auf die Arbeitsfrequenz der Komponente derart, dass diese Frequenz weit über der Resonanzfrequenz des Tiefpasses und möglichst weit außerhalb des Durchlassbereichs des Tiefpasses liegt, mag sichergestellt werden, dass Störungen, insbesondere Wechselstromstörungen (AC-Störungen, Alternating Current-Störungen) oder Spannungs-Rippel, die von der Komponente erzeugt werden, gedämpft werden und sich möglichst nicht oder nur in geringen Massen auf den Gleichstromkreis und/oder den Zwischenkreis ausbreiten, an dem die Komponente angeschlossen ist.

Trotz dieser Vorsichtsmaßnahmen kann es jedoch vorkommen, dass auf dem Zwischenkreis Störungen in Form von Wechselspannungen (AC) oder Spannungs-Rippel entstehen, die eine Frequenz aufweisen, welche tiefer als die Arbeitsfrequenz einer Komponente liegt, jedoch in dem Resonanzfrequenzbereich des zu der Komponente gehörenden Zwischenkreisfilters liegt. Eine solche Störung ist dann in der Lage Resonanzschwingungen in dem Filter zu erzeugen, die zu einer Spannungsüberhöhung führen können, welche wiederum Bauelemente der Komponente schädigen können, da die Spannungsüberhöhung in die Richtung der internen Bauelemente der Komponente gerichtet ist. Oder in anderen Worten, kann der Aufbau einer Filterkomponente, beispielsweise ein Filter zweiter oder höherer Ordnung, zwar Störungen im Bereich der Arbeitsfrequenz der Komponente dämpfen, die sich von der Komponente in Richtung Zwischenkreis ausbreiten. Jedoch können sich Schwingungen (AC) geringer Frequenz, welche sich in dem Zwischenkreis in Richtung der inneren Bauteile der Komponente ausbreiten und welche eine Frequenz im Bereich der Resonanzfrequenz aufweisen, derart verstärken, dass sie zu einer Schädigung der Bauteile der Komponenten führen können. Oder in noch anderen Worten, dämpft das Zwischenkreisfilter Wechsel-Störungen (AC) im Bereich der Arbeitsfrequenz der Komponente gut in Richtung des Zwischenkreises, verstärkt jedoch Wechsel-Störungen (AC), die eine Frequenz im Bereich der Resonanzfrequenz aufweisen, und sich von dem Zwischenkreis in Richtung der Komponente ausbreiten und insbesondere in Richtung des Innenbereichs der Komponente.

Es könnten zwar die Störungen, die sich von dem Zwischenkreis in Richtung der Komponente ausbreiten, mit Hilfe von zusätzlichen Filtern und/oder einem für einen entsprechend großen Frequenzbereich ausgelegtem Filter durch Dämpfen unterdrückt werden. Jedoch müssten die Filter entsprechend groß ausgelegt werden, wodurch Gewicht und Kosten des Filters steigen würden. Außerdem ist das Dämpfen mit Energieverlusten verbunden und könnte zu hohen Verlusten führen. Mit Hilfe der erfindungsgemäßen Entstörvorrichtung kann jedoch der durch die Spannungsüberhöhung hervorgerufene Strom genutzt werden, indem er in den Zwischenkreis oder Gleichstromkreis zurück gespeist oder eingeprägt wird und die in ihm enthaltene Energie im Wesentlichen erhalten wird, also nicht vernichtet wird.

Der Sensor zum berührungslosen Koppeln mit dem ersten Leiter des Gleichstromkreises weist eine Spule auf, um mit dem Gleichstromkreis einen Transformator mit einem vorgebbaren Koppelfaktor zu bilden.

Mittels der Spule kann im Wesentlichen verlustfrei ein Strom in der Entstörvorrichtung abgegriffen werden, der zurück in den Gleichstromkreis oder den Zwischenkreis geleitet werden kann, um der Störung entgegenzuwirken. Die Entstörspule kann auf einem gemeinsamen Ferritkern mit der Zwischenkreisfilterspule aufgewickelt sein. Die Spulen sind im Wesentlichen galvanisch getrennt, insbesondere in Bezug zu der Spannungsübertragung. Der Koppelfaktor k gibt an, wie sehr die Kopplung einer idealen Kopplung entspricht. Bei einer idealen Kopplung ist der Koppelfaktor k=1, d.h. der gesamte magnetische Fluß durch die Primärspule entspricht dem Fluss durch die Sekundär Spule. Bei einer realen Kopplung kann ein Streufluss auftreten, so dass k<1 ist, beispielsweise kann k=0.9 betragen. Das Windungsverhältnis der Entstörspule zur Zwischenkreisfilterspule kann beispielsweise 1:10 oder 1:20 betragen, unabhängig von dem Koppelfaktor k.

Ein erster Anschluss der Spule, insbesondere ein erster Anschluss der Entstörspule, ist mit dem ersten Anschluss und ein zweiter Anschluss der Spule über zumindest einen Kondensator, insbesondere über den Entstörkondensator, und über zumindest eine Diode mit dem ersten Anschluss verbunden. Durch diese Art und Weise der Verschaltung der Entstörspule lässt sich ein mittels der Entstörspule abgegriffener Strom in den ersten Anschluss und somit in den Zwischenkreis einprägen und/oder zurückführen.

Ein Anschluss des zumindest einen Kondensators, insbesondere des Entstörkondensators, ist über eine weitere Diode mit dem zweiten Anschluss verbunden.

Bei dem zweiten Anschluss kann es sich um ein Bezugspotential handeln, beispielsweise um Masse.

Gemäß einem weiteren Aspekt der vorliegenden Erfindung sind der erste Anschluss und der zweite Anschluss zum Verbinden mit einer Fahrzeugkomponente ausgebildet.

Sollte die Entstörvorrichtung zum nachträglichen Einbau in einen Zwischenkreis vorgesehen sein, können beispielsweise der erste und der zweite Anschluss mittels einer bei Zwischenkreisen üblichen Steckverbindung erfolgen, was das Nachrüsten eines Zwischenkreises mit der Entstöreinrichtung sehr vereinfacht. Zusätzlich zum Anschließen der Entstöreinrichtung an dem ersten Leiter und an dem zweiten Leiter mag es notwendig sein, die Entstörspule in die Nähe der Zwischenkreisspule zu bringen, um einen guten Koppelfaktor bereitstellen zu können.

Der Sensor der Entstörvorrichtung ist dazu ausgebildet, mit einer Filter-Spule und/oder Leitungsinduktivität eines Gleichstromkreises gekoppelt zu werden.

Um die Effektivität einer Kopplung zu erhöhen kann die Zuleitung durch zumindest einen Ringkern geführt werden. Wird die Zuleitung durch einen oder eine Vielzahl von Ringkerne geführt, die mit der Entstörspule bewickelt sind, so wirkt diese Leitungsinduktivität als Zwischenkreisfilterspule, da die Leitungsinduktivität mittels des einen und/oder der Vielzahl von Ringkernen vergrößert wird.

Je nach Ausprägung der Leitungsinduktivitäten müssen nicht nur die Filterspule oder Zwischenkreisfilterspule sondern auch noch Leitungsinduktivitäten berücksichtigt werden, die zu der Kopplung und/oder zu der Störung durch die eingeprägte Wechselspannung (AC) beitragen. Diese sind ggf. bei der Dimensionierung der Entstörspule oder der Bestimmung der Windungszahl zu berücksichtigen.

Gemäß einem weiteren Aspekt der vorliegenden Erfindung ist die Entstörvorrichtung dazu eingerichtet, mit einem Gleichstromkreis oder Gleichstrom-Zwischenkreis verbunden zu werden, der eine Gleichspannung von 400 V oder 900 V aufweist.

Gemäß einem weiteren Aspekt der vorliegenden Erfindung weist die Entstörvorrichtung ein Gehäuse auf, wobei das Gehäuse zum Befestigen an einem Fahrzeug ausgebildet ist. Das Gehäuse kann ein robustes Gehäuse sein, das die Standards zum Einbau von Zusatzkomponenten in ein Fahrzeug erfüllt, insbesondere in ein Elektrofahrzeug.

Gemäß einem Aspekt der vorliegenden Erfindung wird eine Entstörvorrichtung angegeben, die an einem Gleichstromnetz oder Zwischenkreis angeschlossen ist. Der Zwischenkreis mag eine Vielzahl von Induktivitäten und Kapazitäten aufweisen, die im Wesentlichen von den Zwischenkreisfiltern der an dem Gleichstromnetz angeschlossenen Komponenten gebildet werden. Bei Anregung mit einer Wechselspannung mit einer definierten Frequenz oberhalb einer definierten Amplitude wird die Schwingkreisamplitude von dem LC Filter begrenzt und die Energie der Entstörvorrichtung, des Schwingkreises oder des LC Filters mag als Gleichstrom in das Gleichstromnetz zurückgespeist werden. Für jede Frequenz kann eine andere maximal zulässige Amplitude vorgegeben sein. Insbesondere dann, wenn die Zwischenkreisfilter unterschiedlicher Komponenten unterschiedliche Resonanzfrequenzen und/oder unterschiedliche maximal zulässige Amplituden oder Spannungsamplituden aufweisen mag für jede Frequenz eine andere maximal zulässige Amplitude vorgegeben sein. Um die Entstörung für jede Komponente individuell durchzuführen, wird jede separat am HV-Bus (High-Voltage-Bus, Hochspannungsbus, Zwischenkreis) angeschlossene Komponente einzeln entstört. Um eine Komponente zu definieren kann beispielsweise das Gehäuse als Komponentengrenze festgelegt werden. Auf diese Weise ist es auch möglich, falls sich mehrere Komponenten im selben Gehäuse befinden, den gemeinsamen Anschluss zum HV-Bus für alle Komponenten gemeinsam zu entstören.

Im Wesentlichen liegt der Erfindung die Erkenntnis zugrunde, dass ein Schwingkreis, welcher die Ausbreitung einer Störung von einer Komponente in die Richtung zu anderen Komponenten, verhindern soll, eine Störung verstärkt zu der Komponente weitergibt, wenn eine Störung in umgekehrter Richtung von anderen Komponenten auf den Schwingkreis trifft. Oder in anderen Worten mag das bedeuten, dass sich ein Schwingkreis bei unterschiedlichen Frequenzen in unterschiedliche Richtungen unsymmetrisch verhält.

Kurze Beschreibung der Figuren

Im Folgenden werden weitere exemplarische Ausführungsbeispiele der vorliegenden Erfindung mit Verweis auf die Figuren beschrieben.

Fig. 1 Zeigt einen Hochspannungs-Zwischenkreis mit angeschlossenen Komponenten gemäß einem exemplarischen Ausführungsbeispiel der vorliegenden Erfindung.
Fig. 2 zeigt ein Teilersatzschaltbild der Filterbauteile der Komponenten des Zwischenkreises aus Fig. 1 gemäß einem exemplarischen Ausführungsbeispiel der vorliegenden Erfindung.
Fig. 3 zeigt ein Ersatzschaltbild für eine Entstörvorrichtung, welche an einen Zwischenkreis und ein Zwischenkreisfilter einer Komponente angeschlossen ist.
Fig. 4 zeigt eine Selektion von Frequenzdiagrammen für ein Störsignal mit einer geringen Störamplitude gemäß einem exemplarischen Ausführungsbeispiel der vorliegenden Erfindung.
Fig. 5a zeigt eine Selektion von Frequenzdiagrammen für ein Störsignal mit einer großen Störamplitude bei 900V Zwischenkreisspannung gemäß einem exemplarischen Ausführungsbeispiel der vorliegenden Erfindung.
Fig. 5b zeigt eine Selektion von Frequenzdiagrammen für ein Störsignal mit einer großen Störamplitude bei 450V Zwischenkreisspannung gemäß einem exemplarischen Ausführungsbeispiel der vorliegenden Erfindung.
Fig. 6 zeigt ein Ersatzschaltbild für eine weitere Ausgestaltung einer Entstörvorrichtung mit vervielfachten Elementen gemäß einem exemplarischen Ausführungsbeispiel der vorliegenden Erfindung.

Detaillierte Beschreibung von Ausführungsbeispielen

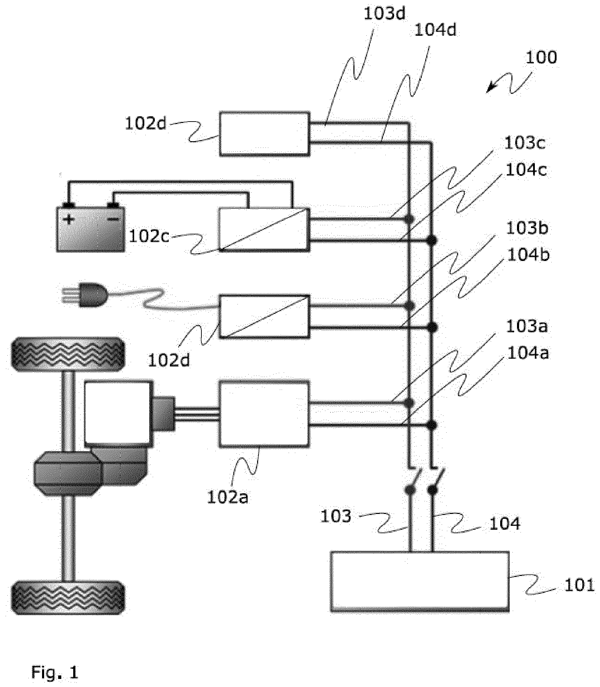

Die Darstellungen in den Figuren sind schematisch und nicht maßstäblich. In der folgenden Beschreibung der Fig. 1 bis Fig. 6 werden die gleichen Bezugsziffern für gleiche oder sich entsprechende Elemente verwendet.
Fig. 1 Zeigt einen Zwischenkreis 100 oder HV-Bus 100 mit angeschlossenen Komponenten 102a, 102b, 102c, 102d gemäß einem exemplarischen Ausführungsbeispiel der vorliegenden Erfindung. Der Hochspannungs-Zwischenkreis 100 eines Elektro- und Hybridfahrzeugs weist eine erste Leitung 103 und eine zweite Leitung 104 auf. Diese werden von der Batterie 101, beispielsweise einer Li-Ion Batterie, mit einer Gleichspannung (DC, Direct Current) von 400 V, 450 V oder 900 V versorgt. Die Spannungen können beliebig gewählt werden. Ohne Einschränkung der Allgemeinheit können auch Spannungen 300 V, 350 V, 400 V, 450 V, 500 V, 550 V, 600 V, 650 V, 700 V, 750 V, 800 V, 850 V und 900 V gewählt werden. Insbesondere sind auch beliebige Spannungen aus dem Bereich von 300 V bis 900 V. Die Spannungen können auch innerhalb eines Toleranzbereichs der angegebenen Werte liegen. An den Hochspannungs-Zwischenkreis 100 sind mehrere Komponenten 102a, 102b, 102c, 102d angeschlossen. Bei den Komponenten handelt es sich um die Hochvolt-Batterie 101, den Antriebs-Umrichter 102a, der mit dem Motor verbunden ist, den Bordnetzwandler 102b, das Ladegerät 102c oder den DC-DC Wandler 102c, den AC/DC Wandler 102d, den Klimakompressor-Umrichter und beliebig viele andere Komponenten. Mit Ausnahme der Batterie 101 befinden sich in diesen Komponenten 102a, 102b, 102c, 102d elektronische Umformer, welche den Zwischenkreis 100 mit einer Taktfrequenz im Bereich von 5 bis 500kHz periodisch mit zum Teil hohen Strömen belasten. Diese Umformer weisen Schalter auf, die entsprechend mit der jeweiligen Taktfrequenz der zugehörigen Komponente umgeschaltet werden.

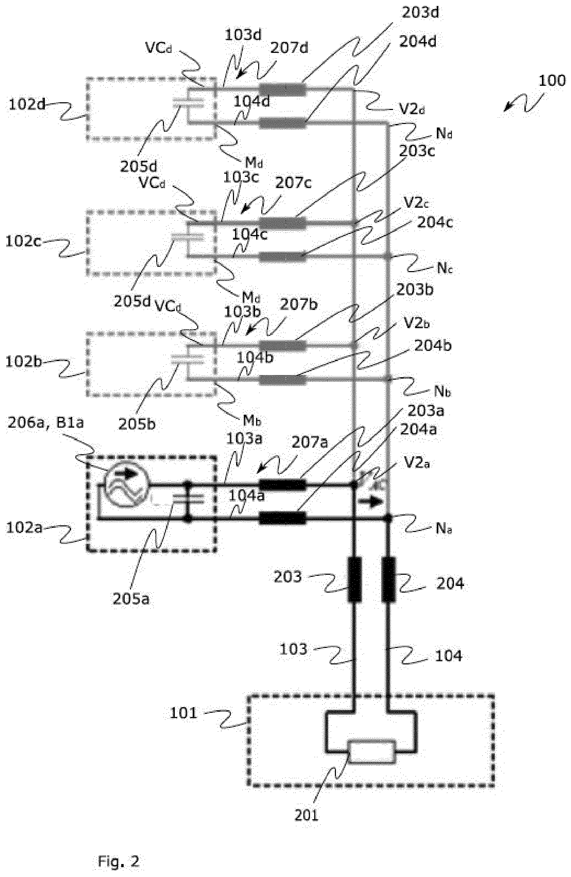

Die Fig. 2 zeigt ein Teilersatzschaltbild der Filterbauteile der Komponenten 101, 102a, 102b, 102c, 102d des Zwischenkreises 100 aus Fig. 1 gemäß einem exemplarischen Ausführungsbeispiel der vorliegenden Erfindung. Fig. 2 zeigt dabei insbesondere ein Ersatzschaltbild, welches sich für eine Stör-Wechselspannung 206a ergibt, die sich in dem Inverter 102a durch Umschaltvorgänge ergeben kann. In jeder der Komponenten 102a, 102b, 102c, 102d, die einen Umschalter aufweist, der mit einer bestimmten Frequenz betrieben wird, können sich durch das Umschalten Belastungen oder Störungen in Form einer Wechselspannung (AC) 206a oder eines Spannungsrippels 206a bilden. Die Störspannung 206a, insbesondere die Störwechselspannung 206a kann als eine Spannungsquelle 206a, B1a aufgefasst werden.
In Fig. 2 ist die Entstehung einer Störung für den Fall des Inverters 102a für die Energieversorgung eines 100kW Antriebsmotors für ein Elektrofahrzeug dargestellt, der als Generator einen Antriebsstrom von 400 A für den Antriebsmotor des Fahrzeugs erzeugt. Der Störstrom 206a wird durch den Zwischenkreiskondensator 205a aufgenommen, wodurch eine Störspannung am Zwischenkreis 100, 103, 104 bzw. am HV-DC-Bus 100, 103, 104 entsteht, die prinzipiell alle daran angeschlossenen Filterkreise zu Schwingungen anregen kann. Die dadurch verursachten Störungen 206a können sich ausgehend von der verursachenden Komponente 102a in Richtung des Zwischenkreises 100 ausbreiten und über den Zwischenkreis 100 die jeweils anderen Komponenten 102b, 102c, 102d erreichen. Der Zwischenkreis 100 oder DC-Bus 100 wird als Gleichstromkreis (DC) betrieben. Von der Batterie 101 wird eine Gleichspannung VB in der Höhe von beispielsweise 400V, 450V oder 900V erzeugt, der sich die Störwechselspannung $V_{AC}$ überlagert. Damit diese durch die Stör-Wechselspannung 206a hervorgerufene Belastung nicht die Funktion anderer am Zwischenkreis 100 angeschlossenen Komponenten 102b, 102c, 102d beeinträchtigt, befindet sich in dem Inverter 102a ein Zwischenkreisfilter 207a, welches den Zwischenkreisfilterkondensator 205a und die am positiven Leiter 103a oder am ersten Leiter 103a angeschlossene positive Zwischenkreisfilterspule 203a und die am negativen Leiter 104a oder zweiten Leiter 104a angeschlossene negative Zwischenkreisfilterspule 204a aufweist.

Ein solches Zwischenkreisfilter 207a, 207b, 207c, 207d befindet sich in jeder Komponente 102a, 102b, 102c, 102d, die als potenzieller Störer dienen kann. Es kann aber auch alternativ oder zusätzlich an den Komponentenanschlüssen des Zwischenkreises angeordnet sein und somit zu dem Zwischenkreis gehörig sein. Komponenten 102a, 102b, 102c, 102d können sich ein Zwischenkreisfilter teilen, wenn sie sich nahe beieinander im selben Gehäuse befinden und über eine gemeinsame Zuleitung mit dem Zwischenkreis 100 verbunden sind. Der Zwischenkreiskondensator 205a, 205b, 205c, 205d eines Zwischenkreisfilters ist möglichst nahe an den aktiven Schaltelementen (in Fig. 2 nicht dargestellt) der jeweiligen Komponente 102a, 102b, 102c, 102d angeordnet. Somit ist auch in jeder dieser Komponenten 102a, 102b, 102c, 102d ein Zwischenkreiskondensator 205b, 205c, 205d oder Zwischenkreisfilterkondensator 205b, 205c, 205d mit einer Kapazität vorhanden, die im Bereich von 10 bis 1000 $\mu$F liegt. Außerdem werden diese Komponenten 102b, 102c, 102d über Filterinduktivitäten 203b, 204b, 203c, 204c, 203d, 204d, Zwischenkreisfilterinduktivitäten 203b, 204b, 203c, 204c, 203d, 204d oder Zwischenkreisinduktivitäten 203b, 204b, 203c, 204c, 203d, 204d mit dem Zwischenkreis 100 verbunden. Die Batterie 101 weist einen Innenwiderstand 201 von 0,1 $\Omega$ auf, der eine Dämpfung für den gebildeten Schwingkreis bewirkt. Der Zwischenkreis 100 weist außerdem eine Leitungsinduktivität 203 in der positiven Busleitung 103 und eine Leitungsinduktivität 204 in der negativen Busleitung 104 auf.

Die Zwischenkreisfilter 207a, 207b, 207c, 207d bilden durch die Zusammenschaltung des jeweiligen Filterkondensators 205b, 205c, 205 mit den jeweiligen Filterinduktivitäten 203b, 204b, 203c, 204c, 203d, 204d ein Tiefpassfilter, das auf die Filterung von Störungen im Bereich der typischen Taktfrequenz der jeweiligen Komponente und der von ihr erzeugten Störung ausgelegt ist und Störungen mit Frequenzen in diesem Frequenzbereich stark dämpft. Da es sich bei dem gebildeten Tiefpassfilter um ein Filter 2. Ordnung handelt, weist jedes Filter eine Resonanzfrequenz auf. Diese

$$f_0 = \frac{1}{2\pi\sqrt{LC}}$$

Resonanzfrequenz $f_0$ eines jeden der Zwischenkreisfilter 207a, 207b, 207c, 207d wird nach der Formel berechnet, wobei sich die Induktivität L aus der Zusammenschaltung der jeweiligen positiven und negativen Zwischenkreisfilterspulen 203a, 204a, 203b, 204b, 203c, 204c, 203c, 204c und die Kapazität C der jeweiligen Kapazität des zugehörigen Zwischenkreisfilterkondensators 205a, 205b, 205c, 205d entspricht.

Diese Resonanzfrequenz $f_0$ liegt unterhalb der typischen Taktfrequenz der Komponente, für die das Zwischenkreisfilter 207a, 207b, 207c, 207d ausgelegt ist. Die Resonanzfrequenz $f_0$ liegt daher in dem Durchlassbereich des Zwischenkreisfilters. Folglich stellt das Zwischenkreisfilter 207a, 207b, 207c, 207d nicht nur eine dämpfende Einrichtung für die von der jeweiligen Komponenten erzeugten Störung dar, sondern bildet auch einen Schwingkreis, der den Zwischenkreisfilterkondensator 205a, 205b, 205c, 205d, die Zwischenkreisfilterspule und ggf. auch noch Anteile der Induktivität der Zuleitung aufweist.

In dem Zwischenkreis 100 aus Fig. 2, in dem keine Entstörvorrichtung zum Einsatz kommt, tragen die Induktivitäten der Zuleitungen mit dem jeweiligen Zwischenkreisfilterkondensator 205a, 205b, 205c, 205d zu der Durchlässigkeit für Störungen in Richtung der Komponente 102a, 102b, 102c, 102d bei. Die Leistungsinduktivität 203a, 204a, 203b, 204b, 203c, 204c, 203c, 204c ist jedoch schwer lokalisierbar. Diese ist in Fig. 2 als ein Spulenbauteil 203a, 204a, 203b, 204b, 203c, 204c, 203c, 204c eingezeichnet. Um die Leitungsinduktivität in einer praktischen beispielhaften Realisierung lokalisieren zu können, und um die Entstörspule an dieser Position anordnen zu können, kann die Zuleitung 103a, 104a, 103b, 104b, 103c, 104c, 103d, 104d durch einen Ringkern und/oder eine Vielzahl von Ringkernen (in Fig. 2 nicht gezeigt) geführt werden. Dieser Ringkern kann auch genutzt werden, um die Effektivität einer Kopplung zu erhöhen. Wird die Zuleitung durch den Ringkern geführt, der mit der Entstörspule bewickelt ist, so wirkt diese Leitungsinduktivität als Zwischenkreisfilterspule 203a, 204a, 203b, 204b, 203c, 204c, 203d, 204d, da die Leitungsinduktivität mittels der Ringkerne vergrößert wird. Die durch den Ringkern geführte Zwischenkreisfilterspule 203a, 204a, 203b, 204b, 203c, 204c, 203c, 204c kann auch als Spule L2 bezeichnet werden. Die um den Ringkern gewickelte Entstörspule kann als L3 bezeichnet werden.

Zur Auslegung geeigneter Entstörvorrichtungen für die Zwischenkreisfilter 207a, 207b, 207c, 207d werden die Bestandteile der einzelnen Zwischenkreisfilter 207a, 207b, 207c, 207d berücksichtigt. Die Zwischenkreisfilter 207a, 207b, 207c, 207d werden zwar alle gemeinsam durch die selbe Störquelle 206a, B1a angeregt, jedoch hat der anregende Schaltkreis 102a, der die Störquelle 206a, B1a enthält, bei einer Realisierung oftmals eine derart tiefe Impedanz im Vergleich zu den übrigen Filterkreisen 207b, 207c, 207d, so dass die von dem Störkreis 207a angeregten Filterkreise 207b, 207c, 207d in einer Näherung als voneinander entkoppelt betrachtet werden können. Da sämtliche der Zwischenkreisfilter 207a, 207b, 207c, 207d über den Zwischenkreis 100 verbunden sind, bilden deren Zwischenkreisfilterkondensatoren 205a, 205b, 205c, 205d mit den Zwischenkreisfilterspulen 203a, 204a, 203b, 204b, 203c, 204c, 203d, 204d und ggf. mit den Leitungsinduktivitäten 203a, 204a, 203b, 204b, 203c, 204c, 203d, 204d ein Netzwerk von Schwingkreisen 207a, 207b, 207c, 207d. In dem Ausführungsbeispiel nach Fig. 2 sind nur Zwischenkreisfilterkondensatoren 205a, 205b, 205c, 205d dargestellt. In diesem Fall können die Zwischenkreisfilterkondensatoren 205a, 205b, 205c, 205d auch als Zwischenkreiskondensatoren bezeichnet werden. In einem anderen Ausführungsbeispiel können Zwischenkreiskondensatoren zusätzlich zu den Zwischenkreisfilterkondensatoren (ZK-Filterkondensator) vorhanden sein. Ein Zwischenkreiskondensator ist dabei definiert als ein Kondensator, der unmittelbar mit den Schaltern, insbesondere mit den Halbleiterschaltern, der der Komponenten 102a, 102b, 102c, 102d verbunden ist, während ein ZK-Filterkondensator 205a, 205b, 205c, 205d oder Zwischenkreisfilterkondensator 205a, 205b, 205c, 205d einer Filterdrossel 203a, 204a, 203b, 204b, 203c, 204c, 203d, 204d nachgeschaltet ist, um einen Filterkreise 207a, 207b, 207c, 207d zu bilden. Zwischenkreisfilterkondensatoren und zusätzliche Zwischenkreiskondensatoren sind beispielsweise bei mehrstufigen Filtern vorhanden.

Da oftmals unterschiedliche Komponenten über den Zwischenkreis zusammengeschaltet werden und die Komponenten mit unterschiedlichen Frequenzen arbeiten und dementsprechend die einzelnen Komponenten Filter mit unterschiedlichen Resonanzfrequenzen enthalten, kann es vorkommen, dass die Arbeitsfrequenz einer Komponente, z.B. des Umrichters 102a, genau auf der Filter-Resonanzfrequenz einer anderen Komponente, z.B. dem Bordnetzwandler 102c, zu liegen kommt und insbesondere auf der Resonanzfrequenz des Zwischenkreisfilters 207c zu liegen kommt. Daher würde der von den Elementen 203c, 204c, 205c des Zwischenkreisfilters 207c gebildete Schwingkreis zu Schwingungen angeregt. Die Arbeitsfrequenz entspricht dabei der typischen Taktfrequenz der jeweiligen Komponente. In dem beschriebenen Beispiel entspräche die Arbeitsfrequenz des Umrichters 102a im Wesentlichen der Resonanzfrequenz $f_0$ des Zwischenkreisfilters 107c des Bordnetzwandlers 102c. Und selbst, wenn der auf die Arbeitsfrequenz der Störkomponente 102a abgestimmte Zwischenkreisfilter den Großteil der Störungen unterdrückt, können sich Störungen einer entsprechenden Frequenz auf dem Zwischenkreis 100 ausbreiten.

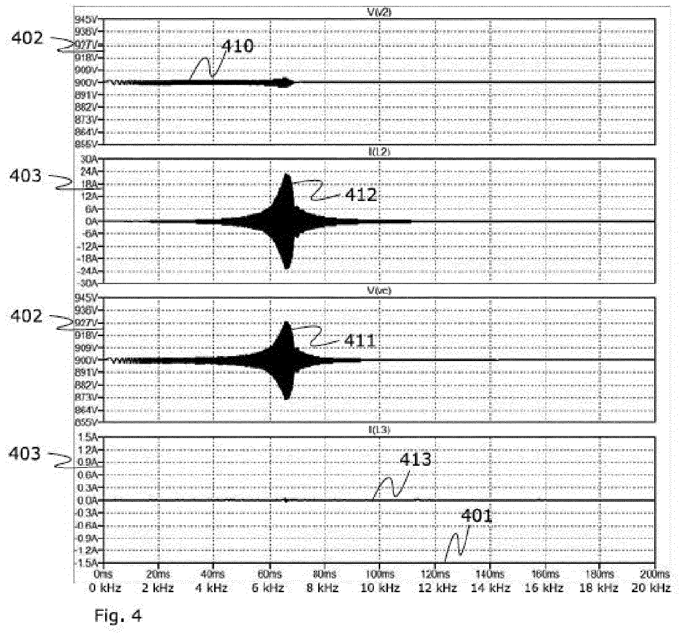

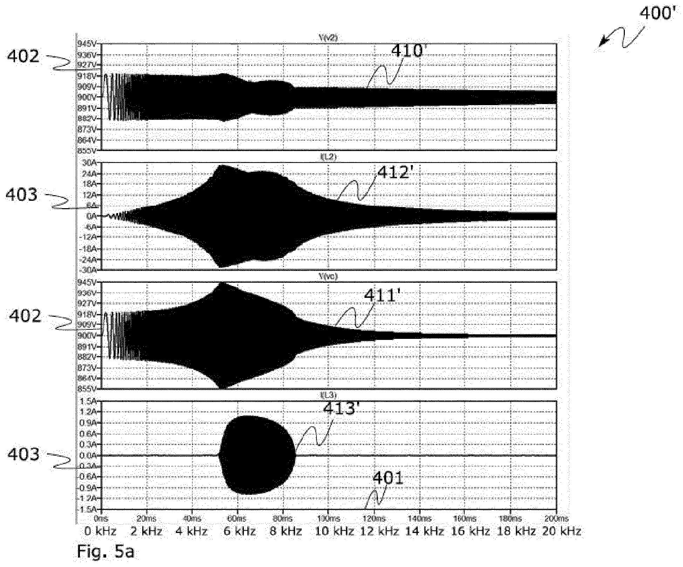

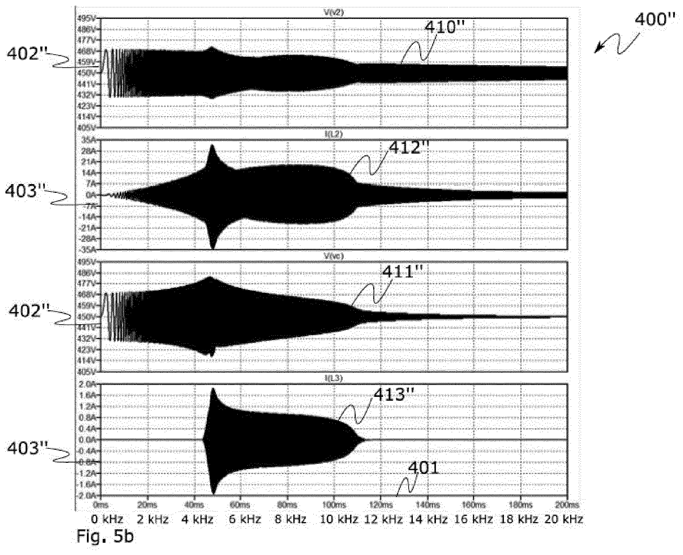

Das Anregen der Filter-Resonanzfrequenz in dem Zwischenkreisfilter der anderen Komponente 102c kann zu so hohen Verlusten in den beteiligten Drosseln, Spulen und/oder Kondensatoren des Zwischenkreisfilters der anderen Komponente 102c führen, z.B. in den Bauelementen des Bordnetzwandlers 102c, dass die Bauelemente (nicht in Fig. 2 dargestellt) der anderen Komponente 102c überlastet werden und ausfallen. In anderen Worten kann es durch das Anregen einer Resonanzfrequenz in einem Zwischenkreisfilter zu einer Amplitudenüberhöhung der Schwingung kommen, insbesondere zu einer Spannungsüberhöhung, die an einzelnen Bauelementen der anderen Komponente 102c zu einer Überlastung führt, die dann dadurch ausfallen können. Diese Spannungserhöhung wird in den Figuren Fig.4, Fig. 5a und Fig.5b beschrieben. Die Komponenten 102a, 102b, 102c, 102d sind über die Zwischenkreisfilter 207a, 207b, 207c, 207d an den positiven Verbindungskontakten V2a, V2b, V2c, V2d mit der positiven Leitung 103 des Zwischenkreises 100 verbunden und über die negativen Verbindungskontakte Na, Nb, Nc, Nd mit der negativen Leitung 104 des Zwischenkreises 100 verbunden.

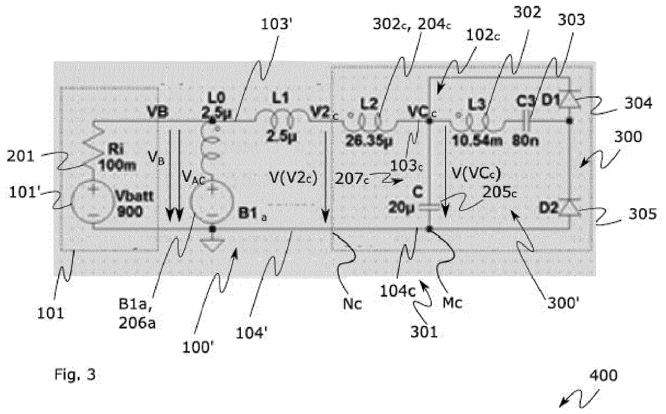

Fig. 3 zeigt ein Ersatzschaltbild für eine Entstörvorrichtung 300, welche an einen Zwischenkreis und ein Zwischenkreisfilter einer Komponente angeschlossen ist, gemäß einem exemplarischen Ausführungsbeispiel der vorliegenden Erfindung. Die gesamte Schaltung 301 der Fig. 3 ist ein Simulationsdiagramm, welches im Wesentlichen den Einfluss der Störung 206a auf eine gestörte Komponente 102c samt Zwischenkreisfilter 207c simuliert. Da sich die einzelnen Störungen in den Frequenzen unterscheiden, auf die das jeweilige Zwischenkreisfilter 207c mit Resonanz reagiert, ist es zulässig, jede Störung durch eine Störquelle B1a, 206a unabhängig von den anderen Störungen zu betrachten. Sämtliche für die Simulation der Störung untergeordnete Elemente, wie die Zusammenschaltung des Zwischenkreises 100 mit den Zwischenkreisfiltern 207b, 207c, 207d, die an der Störung nicht direkt beteiligt sind, werden in dem Zwischenkreis 100' und insbesondere in den Leitungen 103' zusammengefasst. Die Leiter 103c, 104c sind mit den zugehörigen Leitern 103, 104 des Zwischenkreises 100 verbunden.

Der Einsatz der Entstörvorrichtung 300 stellt eine Maßnahme dar, welche genutzt werden kann, um die Amplitude einer resultierenden Störschwingung V(VCc) oder eine resultierende Spannungsamplitude V(VCc) an dem Zwischenfrequenzfilter Ausgang VCc zu reduzieren, die durch eine Eingangs-Störschwingung $V_{AC}$, V(V2c) mit einer bestimmten Frequenz an dem Zwischenkreisfilter Eingang V2c angeregt wird. Die resultierende Störschwingung V(VCc), die am Zwischenfrequenzfilter Ausgang VCc erzeugt wird, mag zur Vereinfachung auch als resultierende Störamplitude V(VCc) bezeichnet werden. Die Komponente, die von der Entstörvorrichtung 300 oder dem Entstörfilter 300 geschützt werden soll, ist in Fig. 3 nicht dargestellt. Bei dieser Komponente könnte es sich aber um den Bordnetzwandler 102c handeln, auf den bereits bei der Beschreibung der Fig. 2 beispielhaft Bezug genommen wurde. Die zu schützende Komponente 102c (nicht in Fig. 2 dargestellt), beispielsweise der Bordnetzwandler 102c, wäre an dem Anschluss VCc mit dem ersten Leiter 103c und am Anschluss Mc mit dem zweiten Leiter 104c verbunden. Die Entstörvorrichtung 300 ist so dimensioniert, dass sie die resultierende Amplitude einer Spannung V(VCc) reduzieren kann, welche von einer Störung erzeugt wird, die von einer Störspannung aus dem Zwischenkreis 100' über das im Wesentlichen in Resonanz schwingende Zwischenkreisfilter 207c an dem Anschluss VCc angeregt wird und so die Spannung an dem Anschluss VCc, an dem eine zu schützende Komponente 102c angeschlossen sein kann, unter einem vorgebbaren Maximalwert hält. Die Entstörvorrichtung begrenzt eine resultierende Spannungsamplitude an einem Komponentenanschluss VCc, Mc auf einen für die Komponente 102c unschädlichen oder akzeptablen Wert und hält auch die damit einhergehende Verlustleistung sehr klein. Dieser Maximalwert kann beispielsweise von einem OEM für einen bestimmten Frequenzbereich vorgegeben werden.

Ein Zwischenkreis-LC-Filter 207c, welches die Zwischenkreisfilterspule 203c, 204c, L2 und die Zwischenkreisfilterkondensator 205, C aufweist, ist an einem Anschluss V2c, Nc an einen Zwischenkreis 100' angeschlossen. Der Zwischenkreis 100' wird von der Versorgungsbatterie 101 oder Gleichstromquelle 101 mit der Zwischenkreisgleichspannung VB=Vbatt-Ri*I mit einer Gleichspannung von 900V versorgt, abzüglich der Spannung an Ri, die von einem durch Ri fließenden Strom I verursacht wird. Die Batterie 101 weist eine Spannungsquelle 101' mit einer konstanten Spannung Vbatt von 900V und dem Innenwiderstand Ri, 201 auf, der beispielsweise 100mΩ betragen kann. Über diese Gleichspannung VB können sich periodische oder alternierende Störspannungen $V_{AC}$ überlagern. Diese Störspannungen können von geschalteten Komponenten verursacht werden, die bei ihren Schaltvorgängen periodische Störsignale anregen können. Zwar weisen die geschalteten Komponenten Filter auf, die die die periodisch angeregten Störungen unterdrücken sollen. Jedoch mag es vorkommen, dass die Filter nicht alle Störungen vollständig eliminieren können. Die stärksten Störungen mögen von den Komponenten hervorgerufen werden, die die größte Leistung in einem Zwischenkreis 100' schalten. Eine Störung, ein Störsignal oder eine Störspannung mag sich der vorhandenen Gleichspannung VB überlagern. Die Spannung, die somit auf dem Zwischenkreis 100' auftritt ist eine Gleichspannung VB = 900V, der eine periodische Störspannung von beispielsweise $V_{AC} = 20V * \llbracket \sin(\square) \, 2\pi f t)$ überlagert ist, wobei *f* die Taktfrequenz der "Anregungsquelle" ist. Die größte "Anregungsquelle" ist meist der Umrichter 102a, von dem in Fig. 3 die von ihm verursachte Störung als Spannungsquelle B1, 206a modelliert ist.

Für das vereinfachte Schema in Fig.3 wird nun angenommen, dass die beiden Zuleitungen 103a, 104a, 103b, 104b, 103c, 104c, 103d, 104d aller Komponenten "sternförmig" zur Batterie 101 hinführen und dort alle in je einem Anschlusspunkt verbunden sind. Die Zuleitungsinduktivitäten 203, 204 sind in Fig.3 nicht dargestellt.

Die Spule L0 ist die die Zusammenfassung der Induktivitäten 203a, 204a inklusive Zuleitungen 103a, 104a zum Umrichter 102a, und L1 ist die Zusammenfassung der Induktivitäten 203c, 204c und Zuleitungen 103c, 104c zu dem Zwischenkreisfilter 207c.

Die Entstörvorrichtung 300 für den Gleichstromkreis 100' oder Zwischenkreis 100', welcher zwei Leiter 103c, 104c aufweist, umfasst einen ersten Anschluss VCc, zum Verbinden der Entstörvorrichtung mit dem ersten Leiter 103' des Gleichstromkreises 100', insbesondere mit einem ersten Leiter 103c des Zwischenkreisfilters 207c der zu schützenden Komponente 102c. Ferner umfasst die Entstörvorrichtung 300 einen zweiten Anschluss Mc, zum Verbinden der Entstörvorrichtung 300 mit einem zweiten Leiter 104' des Gleichstromkreises 100', insbesondere mit einem zweiten Leiter 104c des Zwischenkreisfilters 207c der zu schützenden Komponente 102c. Das Entstörfilter 300 oder die Entstörvorrichtung 300 ist parallel zu der Zwischenkreisfilterkondensator 205c und in Reihe zu der Zwischenkreisfilterspule L2, 203c, 204c geschaltet. Diese Zwischenkreisfilterspule L2, 203c, 204c ist in dem Zwischenkreisfilter 207c als diskretes Bauelement ausgeführt, so dass diese Spule L2, 203c, 204c in dem Zwischenkreisfilter sehr genau lokalisiert werden kann.

Die Anschlüsse VCc, Mc des Entstörfilters können Anschlussleitungen aufweisen. An den Anschlüssen VCc, Mc angeschlossen weist die Entstörvorrichtung 300 einen Sensor 300' auf, der eingerichtet ist, eine Störung zu vermindern, die die Elemente der Komponente 102c gefährdet. Die Komponente 102c ist ebenfalls parallel zu der Entstörvorrichtung 300 an den Anschlüssen VCc, Mc angeschlossen. Für dieses Entgegenwirken oder Kompensieren ist der Sensor 300' dazu eingerichtet, ein Übersteigen eines vorgebbaren Grenzwertes einer überlagerten Wechselspannung $V_{AC}$ in dem ersten Leiter 103', 103c des Gleichstromkreises 100' und insbesondere in dem Zwischenkreisfilter 207c zu erkennen. Der Sensor 300' ist ferner berührungslos oder galvanisch getrennt mit dem Gleichstromkreis 100' oder Zwischenkreis 100' und insbesondere mit dem Zwischenkreisfilter 207c des Zwischenkreises 100' koppelbar. Durch das Aufbringen einer Zuleitung 103c, 104c auf einen Ringkern wird die Spule L2 des Zwischenkreisfilters gebildet, um eine effektive Kopplung mit dem Sensor 300' zu ermöglichen. Der Sensor 300' ist dazu eingerichtet, durch Einprägen eines Stromes in den ersten Anschluss VCc die resultierende Störwechselspannung im ersten Leiter des Gleichstromkreises im Wesentlichen auf den vorgebbaren Grenzwert zu verringern. In anderen Worten wird die resultierende Spannung V(VCc) zwischen den Anschlüssen VCc und Mc unter einen Maximalwert geregelt, indem ein Strom generiert wird, der in den ersten Sensoranschluss VCc eingeprägt werden kann, um im Falle einer Amplitudenüberhöhung der Spannung V(VCc) dieser Amplitudenerhöhung entgegen zu wirken.

Der Sensor 300' weist eine oder mehrere zusätzliche Wicklungen L3, Drosseln L3 oder Spulen L3 auf, die mit der Filterdrossel L2, 203c, 204c des Zwischenkreisfilters 207c magnetisch gekoppelt werden, beispielsweise durch Wickeln auf einen gemeinsamen Ferritkern oder Ringkern. Die Spulen L2, 203c, 204c und L3 bilden dann einen Transformator. Ist keine Filterdrossel L2 in dem Zwischenkreis 100' oder in dem Zwischenkreisfilter 207c vorhanden, so kann diese nachträglich in die Zuleitung 103', 104', 103c, 104c eingebaut werden, beispielsweise indem zumindest eine der Zuleitungen 103c, 104c durch einen Ringkern geführt wird.

Zusätzlich zu der magnetischen oder berührungslosen Kopplung der Spulen L2, 203c, 204c ist ein Anschluss der Filterspule L2, 203c, 204c in dem Anschluss VCc mit einem Anschluss der Sensorspule L3 gekoppelt. In dem Anschluss VCc sind die Anschlüsse der Filterspule L2 und der Sensorspule L3 auch mit einem Anschluss des Filterkondensators C, 205c verbunden. Der andere Anschluss des Filterkondensators C, 205c ist mit dem zweiten Sensoranschluss Mc verbunden. An dem zweiten Anschluss der Sensorspule L3, 302 ist zumindest ein Anschluss eines Sensorkondensators C3, 303 in Reihe mit der Sensorspule L3, 302 geschaltet. Die Sensorspule L3, 302 und der Sensorkondensator C3, 303 bilden somit einen Reihenschwingkreis. Ein zweiter Anschluss des Sensorkondensators C3, 302 ist mit der Anode einer Rückkoppeldiode D1, 304 verbunden. Die Kathode der Rückkoppeldiode D1, 304 ist mit dem Anschluss VCc verbunden. Über die Rückkoppeldiode D1, 304 kann ein mittels der Sensorspule L3, 302 aus dem Zwischenkreis 100' und insbesondere aus dem Zwischenkreisfilter 207c aufgenommener und verstärkter Strom in den Anschluss VCc eingeprägt werden. Die Anode der Rückkoppeldiode D1, 304 ist auch mit der Kathode einer Verbindungsdiode D2, 305 verbunden. Die Anode der Verbindungsdiode ist mit dem zweiten Anschluss Mc verbunden. Folglich sind der erste Anschluss VCc und der zweite Anschluss Mc über die Rückkoppeldiode D1, 304 und die Verbindungsdiode D2, 305 miteinander verbunden. In einem eingebauten Zustand, in dem die Entstörvorrichtung 300 parallel zu dem Zwischenkreisfilterkondensator C, 305 geschaltet ist, ist die Verbindungsdiode D2, 305 im Wesentlichen parallel zu dem Zwischenkreisfilterkondensator C, 305 geschaltet. Der zweite Anschluss ist mit dem Anschluss Nc und mit Bezugspotenzial oder Masse verbunden, wenn die Entstörvorrichtung mit dem Zwischenkreisfilter verbunden ist.

Der Sensorkondensator C3, 303 kann auch aus einer Vielzahl von im Wesentlichen parallelgeschalteter Kondensatoren C3, C4 realisiert sein. Die Dioden D1, 304, D2, 305 können sowohl als eine einzelne als auch als eine Vielzahl von Dioden D1, D2, D3, D4 realisiert sein.

In dem in Fig. 3 dargestellten Beispiel bilden die Wicklungen der Spulen L2, 203c, 204c und L3, 302 einen Transformator mit einem bestimmten Koppelfaktor k, beispielsweise k=0.9. Eine äußere periodische Störung $V_{AC}$, die von der Störquelle B1a, 206a hervorgerufen wird, bewirkt eine resonante Überspannung über L2 und wegen der Kopplung folglich auch über L3. Ist die bewirkte Störspannung genügend groß und die Spannungsübersetzung, die sich aus dem Verhältnis der Anzahl der Wicklungen der gekoppelten Spulen L3, 302, L2, 203c, 204c des von ihnen gebildeten Transformators ergibt, auch groß genug, so beginnt ein periodischer Strom über den Sensorkondensator C3, 303 und die Sensordioden 304, D1, 305, D2 zu fließen. Dieser in dem Sensor 300' induzierte Strom, welcher zu der überlagerten Störung $V_{AC}$ in dem Gleichstromkreis 100' und insbesondere zu der Störung $V_{AC}$ in dem Zwischenkreisfilter 207c proportional ist, wird in den Anschluss VCc eingeprägt und begrenzt die durch die Resonanz entstehende resonante Überspannung $V_{AC}$ indem durch den eingeprägten Strom die Energie, die durch die transformatorische Kopplung in dem Sensor erzeugt wird, in den Zwischenkreis 100' und insbesondre in das Zwischenkreisfilter 207c abgeleitet wird.

In anderen Worten, weist beispielsweise die Spannung V(V2c), die von dem Zwischenkreis durch eine Überlagerung der periodischen Störung $V_{AC}$ von der Störquelle B1a, 206a und der Gleichspannung VB herrührt den Verlauf

$$V(V2c) = VB + V_{AC} = 900V + 20V * [\sin(\square) \, 2\pi f t)$$

auf. Hierbei schwingt die Störung $V_{AC}$ um den Arbeitspunkt 900V. Diese Störung wirkt in einer Richtung vom Zwischenkreis 100' in Richtung Komponente 102c, die an den Anschlüssen VCc und Mc angeschlossen ist, auf das Zwischenkreisfilter 207c, obwohl dieses Filter 207c ursprünglich zur Dämpfung von Störungen vorgesehen ist, die sich von der Komponente 102c auf den Zwischenkreis 100' ausbreiten. Im Bereich der Resonanzfrequenz reagiert die resultierende Spannung an dem Anschlusspaar VCc, Mc mit einer Erhöhung der Amplitude, die zu einem erhöhten Strom in der Zwischenkreisfilterspule L2, 203c, 204c führt. Der Transformator überträgt lediglich den periodischen Anteil der überhöhten Spannung, die an VCc anliegt. Das Windungsverhältnis beträgt beispielsweise 1:20. Folglich wird die überhöhte Spannung mit einer entsprechenden Spannungsübersetzung in den Sensor 300' übertragen. Da die Spulen L2, 203c, 204c und L3, 302 jedoch den gemeinsamen Anschluss VCc haben, pendelt die in dem Sensor induzierte Spannung nicht um den Arbeitspunkt des Zwischenkreis 100, 100' von 900V sondern lediglich um das Mittenpotential zwischen 0 und +900V, also 450V. Solange die induzierte Spannung diese 450V nicht überschreitet, werden die Dioden 304,305 nicht leitend. Wird die induzierte Spannung über L3 grösser als 450V - d.h., die Spannung über L2 ist grösser als 450V/20 = 22.5V -, dann beginnen die Dioden 304, 305 zu leiten und führen einen Teil der in der Schwingung gespeicherten Energie in den Zwischenkreis 100' ab. Das Windungsverhältnis wird so gewählt, dass auch bei der kleinsten auftretenden Zwischenkreisspannung nur das Überschwingen durch die Dioden begrenzt wird. Beim Auftreten der größten spezifizierten Störspannung $V_{AC} = V_{ripple}$ soll die Begrenzung nicht wirksam werden, wenn der Filter-Schwingkreis 207c nicht angeregt wird.

Bei einer genauen Betrachtung ergibt sich folgende beispielhafte brauchbare Dimensionierung. In dem Beispiel sei $V_{ripple}$ = 16Vpk (Peak Spannung) und $V_{DCmin}$ = 450VDC (Spannung des Gleichstromanteils) sowie eine Windungsanzahl $n_3$ der Spule L3 und $n_2$ der Spule L2 angenommen:

$$\frac{n_3}{n_2} = \sqrt{\frac{L_3}{L_2}} \approx \frac{V_{DC\min}}{\sqrt{2} \cdot V_{ripple}} = \frac{450V}{\sqrt{2} \cdot 16V_{pk}} \approx 20$$

Es ergibt sich ein Windungsverhältnis von 1:20. L2 und C sind durch die Dimensionierung der Komponente und des zugehörigen Zwischenkreisfilters 207c bereits vorbestimmt. Eine Kopplung k=0.9 mag zu einem guten Ergebnis führen, und C3 wird so gewählt, dass sich über alle Arbeitspunkte ein möglichst kleiner Drosselstrom durch L2, 203c, 204c ergibt. Ein gutes Ergebnis ist beispielsweise zu erzielen, wenn C3 so gewählt wird, dass gilt:

$$C_3 \cdot L_3 \approx 1{,}6 \cdot C \cdot L_2 \qquad \text{d.h.} \qquad C_3 \approx C \cdot 1{,}6 \cdot \left(\frac{n_2}{n_3}\right)^2$$

Die Tabelle 1 gibt die Dimensionierung der Bauelemente der Schaltung aus Fig. 3 an. Hierin ist C3 entsprechend der oben angegebenen Dimensionierungsvorschrift bestimmt.

Tabelle 1

| Ri | 100mΩ | L0 | 2,5µH |
|---|---|---|---|
| Vbatt | 900V | L1 | 2,5µH |
| C | 20µF | L2 | 26,35µH |
| C3 | 80nF | L3 | 10,54mH |

Fig. 4 zeigt eine Selektion von vier Frequenzdiagrammen 400 für ein Störsignal mit einer geringen Störamplitude gemäß einem exemplarischen Ausführungsbeispiel der vorliegenden Erfindung. Für die Simulation wurde die Schaltung nach Fig. 3, die ein Ersatzschaltbild für einen realen Zwischenkreis in einem Elektrofahrzeug darstellt, mit einer konstanten Störamplitude von 2V und variabler Frequenz beaufschlagt. In dem Diagramm 400 ist an der Abszisse 401 die Frequenz von 0ms bis 200ms bzw. 0 bis 20kHz aufgetragen. Die Abszisse kann in Millisekunden (ms) geeicht sein, wobei die Werte mittels des Umrechnungsfaktors 1kHz/10ms in die zugehörige Frequenz gewandelt werden können, so dass auf der Abszisse ein Frequenzbereich von 0 Hz bis 20kHz dargestellt ist. Die Spannungsordinate 402 gibt Spannungswerte im Bereich von 855V bis 945V an. Die Stromordinate 403 gibt Stromwerte von -30A bis +30A an.

Um die Auswirkungen mit variabler Frequenz darstellen zu können, wird an dem Anschluss V2c die sweep

Funktion $V(V2c) = \boxed{\phantom{}}\ 900V + 2V * \left[\sin(\square)\ 2\pi * 50000\ \frac{1}{s^2} t^2\right)$ angelegt. Der Verlauf der Störspannung V(V2c), 410 ist in Fig. 4 eingezeichnet. Die Störamplitude der Störspannung beträgt $V_{AC}$ = 2V insbesondere $V_{ripple}$ = 2Vpk. Der Spannungsverlauf V(VCc), 411 am Filterausgang an den Komponentenanschlüssen VCc, Mc über dem Zwischenkreiskondensator C, 205c zeigt, dass sich, obwohl sich im Bereich von 6,5 kHz eine Resonanz und insbesondere auch eine Strom- und Spannungsüberhöhung ausbildet, wegen der kleinen Anregung mit einer Störamplitude von 2V nur eine unschädliche Spannungsamplitude von 35V bleibt. Die Entstörvorrichtung kommt daher nicht zum Einsatz, da eine maximal zulässige Spannung an den Anschlüssen VCc, Mc nicht überschritten wird.

Ebenso bleibt der Strom I(L2), 412 durch L2 unter 24A. Der Strom durch L3 I(L3), 413 bleibt im Wesentlichen konstant, wie die Kurve 413 zeigt, die mit einem Faktor von 10 bewertet ist.

Fig. 5a zeigt eine Selektion von Frequenzdiagrammen 400' für ein Störsignal mit einer großen Störamplitude bei 900VDC Zwischenkreisspannung gemäß einem exemplarischen Ausführungsbeispiel der vorliegenden Erfindung.

Es wird an dem Anschluss V2c die sweep Funktion $V(V2c) = \boxed{\phantom{}}\ 900V + 20V * \left[\sin(\square)\ 2\pi * 50000\ \frac{1}{s^2} t^2\right)$ angelegt, also verglichen mit der Störspannung aus Fig. 4 mit einer zehnfachen Störamplitude. Der Verlauf der Störspannung V(V2c), 410' ist in Fig. 5a eingezeichnet. Der Spannungsverlauf V(VCc), 411' am Filterausgang an den Komponentenanschlüssen VCc, Mc über dem Zwischenkreiskondensator C, 205c zeigt, dass sich, obwohl sich in einem breiten Frequenzbereich um wiederum 6,5 kHz eine Resonanz und insbesondere auch eine Strom- und Spannungsüberhöhung ausbildet, die wegen dem Eingreifen der Entstörvorrichtung 300 auf eine Spannungsamplitude von 45V, d.h. von 855V bis 945V begrenzt wird. Gegenüber Fig.4 wird durch die Wirkung der Entstörvorrichtung der Schwerpunkt der Resonanz zu einer etwas tieferen Frequenz verschoben. Wie bereits angeführt, lässt sich mit der oben angegebenen Dimensionierung für C3 ein gutes Ergebnis erreichen. Somit kann sichergestellt werden, dass eine an VCc angeschlossene Komponente nicht mit einer Spannungsamplitude von mehr als 45V belastet wird, wenn beispielsweise gefordert wird, dass über den Frequenzbereich von 0Hz bis 20kHz keine größeren Belastungen auftreten sollen oder, dass größere Belastungen vermieden werden.

Der Strom I(L2), 412' durch die Spule L2 bleibt über dem gesamten Frequenzbereich unter 30A. Der Verlauf der Stromkurve I(L3), 413' zeigt, dass in einem Bereich von 5,2kHz bis 8.6kHz ein hoher Strom durch L3 fließt und daher die Entstörvorrichtung aktiv wird. Ohne das Eingreifen der Entstörvorrichtung würde die Spannungsamplitude V(VCc), 411' in dem Frequenzbereich um 6.5 kHz eine Spannungsamplitude von 350V erreichen, wodurch eine an VCc angeschlossene Komponente zerstört werden könnte. In dem Beispiel nach Fig. 4 greift die Entstörvorrichtung wegen der geringen Anregungsspannung nicht ein. Durch die 10-fache Anregung gegenüber der der Fig.4 zugrundeliegenden

$$V(V2c) = \; 900V + 2V * \left[\sin(\;) 2\pi * 50000\frac{1}{s^2}t^2\right)$$

Anregungsfunktion ergäbe sich ohne das Vorhandensein der Entstörvorrichtung 300 auch die 10-fache Spannung, denn das System ohne Entstörvorrichtung verhält sich linear aufgrund der Tatsache, dass es nur lineare Bauteile aufweist.

Fig. 5b zeigt eine Selektion von Frequenzdiagrammen 400" für ein Störsignal mit einer großen Störamplitude bei 450V Zwischenkreisspannung gemäß einem exemplarischen Ausführungsbeispiel der vorliegenden Erfindung. Die Spannungsordinate 402" gibt Spannungswerte im Bereich von 405V bis 495V an. Die Stromordinate 403" gibt Stromwerte von -35A bis +35A an. Es wird an dem Anschluss V2c die sweep Funktion

$$V(V2c) = \; 450V + 20V * \left[\sin(\;) 2\pi * 50000\frac{1}{s^2}t^2\right)$$

angelegt, also verglichen mit der Störspannung aus Fig. 4 mit einer zehnfachen Störamplitude von 20V, jedoch bei einem geringeren Arbeitspunkt von 450VDC. Der Verlauf der Störspannung V(V2c), 410" ist in Fig. 5b eingezeichnet. Der Spannungsverlauf V(VCc), 411" am Filterausgang an den Komponentenanschlüssen VCc, Mc über dem Zwischenkreiskondensator C, 205c zeigt, dass sich, obwohl sich in einem breiten Frequenzbereich um wiederum 6,5 kHz eine Resonanz und insbesondere auch eine Strom- und Spannungsüberhöhung ausbildet, diese wegen dem Eingreifen der Entstörvorrichtung 300 auf eine Spannungsamplitude von 30V, d.h. von 420V bis 480V begrenzt wird. Gegenüber Fig.4 wird durch die Wirkung der Entstörvorrichtung der Schwerpunkt der Resonanz zu einer etwas tieferen Frequenz verschoben. Wie bereits angeführt, lässt sich mit der Dimensionierung

$$C_3 \approx C \cdot 1{,}6 \cdot \left(\frac{n_2}{n_3}\right)^2$$

ein gutes Ergebnis erreichen. Somit kann sichergestellt werden, dass eine an VCc angeschlossene Komponente nicht mit einer Spannungsamplitude von mehr als 36V belastet wird, wenn beispielsweise gefordert ist, dass über den Frequenzbereich von 0Hz bis 20kHz keine größeren Belastungen auftreten sollen oder über diesen Bereich größere Belastungen vermieden werden sollen.

Der Strom I(L2), 412" durch die Spule L2 bleibt über dem gesamten Frequenzbereich unter 35A und ist in einem schmalen Frequenzbereich etwas grösser als ein entsprechender Wert von Kurve 412' in Fig. 5a. Der Verlauf der Stromkurve I(L3), 413" zeigt, dass in einem Bereich von 4,5 kHz bis 11 kHz ein hoher Strom durch L3 fließt und daher die Entstörvorrichtung aktiv wird. Ohne das Eingreifen der Entstörvorrichtung würde die Spannungsamplitude V(VCc), 411" in dem Frequenzbereich um 6.5 kHz eine Spannungsamplitude von 350V erreichen, wodurch eine an VCc angeschlossene Komponente zerstört werden könnte. In dem Beispiel nach Fig. 4 greift die Entstörvorrichtung wegen der geringen Anregungsspannung nicht ein. Durch die 10-fache Anregung gegenüber der der Fig.4 zugrundeliegenden

$$V(V2c) = \; 900V + 2V * \left[\sin(\;) 2\pi * 50000\frac{1}{s^2}t^2\right)$$

Anregungsfunktion ergäbe sich ohne dem Vorhandensein der Entstörvorrichtung 300 auch die 10-fache Spannung, denn das System ohne Entstörvorrichtung verhält sich linear, da es nur lineare Bauteile aufweist.

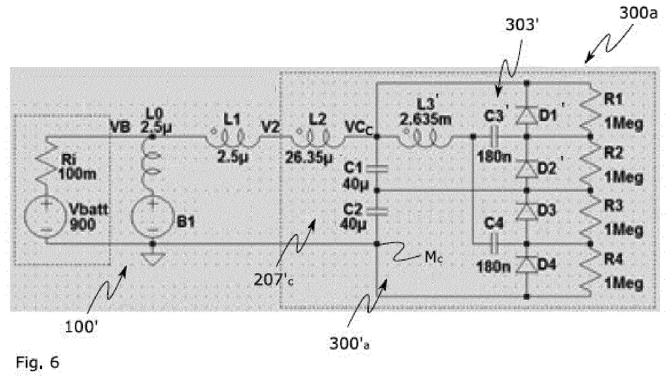

Fig. 6 zeigt eine weitere Ausgestaltung einer Entstörvorrichtung 300a gemäß einem exemplarischen Ausführungsbeispiel der vorliegenden Erfindung. Diese Ausgestaltung erlaubt die Verwendung von kostengünstigeren Bauelementen für den Sensor 300'a. Das Windungsverhältnis beträgt 1: 10 wodurch eine Spule L3 mit einer geringeren Induktivität verwendet werden kann, die günstiger hergestellt werden kann. Der Koppelfaktor beträgt jedoch wie in Fig. 3 k= 0,9. Der Kondensator C3, 303 ist durch ein Kondensatorpaar 303', C3', C4 ersetzt und statt der Dioden D1, D2 werden vier Dioden D1', D2', D3, D4 verwendet, die in einer Serienschaltung angeordnet sind. Parallel zu jeder der Dioden ist ein Widerstand R1, R2, R3, R4 geschaltet.

Auch das Zwischenkreisfilter 207c' hat einen anderen Aufbau als das Zwischenkreisfilter 207c aus Fig. 3. Statt der Kapazität C kommt eine Serienschaltung der Kondensatoren C1, C2 zum Einsatz, um zwischen der Verbindung der Kondensatoren C1, C2 die Anode der Diode D2' und die Kathode der Diode D3 anschließen zu können.

Die Widerstände R1, R2, R3, R4 sind optional, können jedoch eingesetzt werden, um die Konvergenz bei einer Simulation sicherzustellen. Obwohl sich der Aufbau der Entstörvorrichtung 300a in Fig. 6 von dem Aufbau der Entstörvorrichtung 300 aus Fig. 3 unterscheidet, ist die prinzipielle Funktionsweise der Entstörvorrichtungen 300, 300a im Wesentlichen gleich. Allerdings ist bei der Entstörvorrichtung 300a durch die Reihenschaltung von zwei Diodenhalbbrücken D1' D2' und D3, D4 nur die halbe Spannung an L3' gegenüber der Spannung an L3, 302 erforderlich, damit die Schaltung 300a eingreift. Entsprechend kann die Windungszahl von L3' der Entstörvorrichtung 300a gegenüber der Windungszahl von L3, 302, der Entstörvorrichtung 300 halbiert werden. Mit einer Kopplung k=0.9 lassen sich gute Ergebnisse erzielen, und die Kapazitäten der Kondensatoren C3' und C4 werden so gewählt, dass C3'=C4 gilt und dass sich über alle Arbeitspunkte ein möglichst kleiner Drosselstrom durch L2 ergibt. Die Kondensatoren C3' und C4 sind an einem gemeinsamen Anschluss sowohl miteinander als auch mit einem Anschluss der Spule L3' verbunden. Der andere Anschluss des Kondensators C3' ist mit einer Anode der Diode D1' und einer Kathode der Diode D2' verbunden. Die Dioden D1' und D2' bilden eine Diodenhalbbrücke. Der andere Anschluss des Kondensators C4 ist mit einer Anode der Diode D3 und einer Kathode der Diode D4 verbunden. Die Dioden D3 und D4 bilden eine weitere Diodenhalbbrücke. Ein gutes Ergebnis lässt sich erzielen, wenn C3'=C4 gewählt wird, wobei die Werte von C3' und C4 so gewählt werden, dass bei C1=C2 die folgende Bedingung erfüllt ist:

$$C_3' \approx C_1 \cdot 1{,}8 \cdot \left( \frac{n_2}{n_3} \right)^2$$

Die Tabelle 2 gibt die Dimensionierung der Bauelemente der Schaltung aus Fig. 6 an. Dieser Dimensionierung nach Tabelle 2 ist zu entnehmen, dass die Bedingungen C1=C2 und C3'=C4 erfüllt sind. Außerdem stehen die Werte der Kondensatoren C3' und C1 in dem oben angegebenen Zusammenhang.

Tabelle 2

| Ri | 100mΩ | L0 | 2,5μH |
|---|---|---|---|
| Vbatt | 900V | L1 | 2,5μH |
| C1 | 40μF | L2 | 26,35μH |
| C2 | 40μF | L3' | 2,635mH |
| C3' | 180nF | R1=R2=R3=R4 | 1MΩ |
| C4 | 180nF | | |

Ergänzend ist darauf hinzuweisen, dass "umfassend" und "aufweisend" keine anderen Elemente oder Schritte ausschließt und "eine" oder "ein" keine Vielzahl ausschließt.
Bezugszeichen in den Ansprüchen sind nicht als Einschränkung anzusehen.

**Patentansprüche**

1.  Entstörvorrichtung (300, 300a) für einen Gleichstromkreis (100, 100'), welcher zwei Leiter (103', 103c, 104', 104c) aufweist,

    wobei die Entstörvorrichtung (300, 300a) umfasst:

    - einen ersten Komponentenanschluss (VCc), zum Verbinden der Entstörvorrichtung (300, 300a) mit einem ersten Leiter (103', 103c) des Gleichstromkreises (100, 100');
    - einen zweiten Komponentenanschluss (Mc), zum Verbinden der Entstörvorrichtung (300, 300a) mit einem zweiten Leiter (104', 104c) des Gleichstromkreises (100, 100');
    - einen Sensor (300', 300a'), wobei der Sensor:

    ◦ transformatorisch mit dem Gleichstromkreis (100, 100') koppelbar ist;
    ◦ dazu eingerichtet ist, ein Übersteigen eines vorgebbaren Grenzwertes einer überlagerten Wechselspannung in dem ersten Leiter (103', 103c) des Gleichstromkreises zu erkennen; und
    ◦ dazu eingerichtet ist, durch Einprägen eines Stromes in den ersten Komponentenanschluss (VCc) die Wechselspannung im ersten Leiter des Gleichstromkreises auf den vorgebbaren Grenzwert zu verringern;

wobei der Sensor (300', 300a') zum transformatorischen Koppeln mit dem ersten Leiter des Gleichstromkreises eine Spule (302, L3; L3') aufweist, um mit dem Gleichstromkreis (100, 100') einen Transformator mit einem vorgebbaren Koppelfaktor (k) zu bilden;

wobei ein erster Anschluss der Spule (L3; L3') mit dem ersten Komponentenanschluss (VCc) verbunden ist,

**dadurch gekennzeichnet, dass**

ein zweiter Anschluss der Spule (L3; L3') über zumindest einen Kondensator (303, C3; C3', C4) und über zumindest eine Diode ($D_1$, 304, $D_2$, 305; D1', D2', D3, D4) mit dem ersten Komponentenanschluss (VCc) verbunden ist;

wobei ein Anschluss des zumindest einen Kondensators (C3; C3', C4) über eine weitere Diode (D2; D4) mit dem zweiten Komponentenanschluss (Mc), verbunden ist;

wobei die Anode der zumindest einen Diode ($D_1$, 304, $D_2$, 305; D1', D2', D3, D4) mit der Kathode der weiteren Diode (D2; D4) verbunden ist.

2. Entstörvorrichtung (300, 300a) nach Anspruch 1, wobei der erste Komponentenanschluss (VCc) und der zweite Komponentenanschluss (Mc) zum Verbinden mit einer Fahrzeugkomponente (102a, 102b, 102c, 102d) ausgebildet ist.

3. Entstörvorrichtung (300, 300a) nach Anspruch 1 oder 2, deren Sensor (300', 300a') dazu eingerichtet ist, mit einer Filter-Spule (L2, 203c, 204c) und/oder einer Leitungsinduktivität (L2, 203c, 204c) des Gleichstromkreises gekoppelt zu werden.

4. Entstörvorrichtung (300, 300a) nach einem der Ansprüche 1 bis 3, welche dazu eingerichtet ist, mit einem Gleichstromkreis (100, 100') gekoppelt zu werden, der eine Gleichspannung von 400 V oder 900 V aufweist.

5. Entstörvorrichtung (300, 300a) nach einem der Ansprüche 1 bis 4, weiter aufweisend: ein Gehäuse; wobei das Gehäuse zum Befestigen an einem Fahrzeug ausgebildet ist.

6. Komponente (102a, 102b, 102c, 102d) aufweisend:

   - einen Gleichstromkreis (100, 100') mit einem ersten Leiter (103', 103c), einem zweiten Leiter (104', 104c) und einem Zwischenkreis-Filter (207c, 207c') im ersten Leiter;
   - eine Entstörvorrichtung (300, 300a) nach einem der Ansprüche 1 - 5; wobei

      o der erste Komponentenanschluss (VCc) der Entstörvorrichtung mit dem ersten Leiter (103', 103c) verbunden ist;
      o der zweite Komponentenanschluss (Mc) der Entstörvorrichtung mit dem zweiten Leiter (104', 104c) verbunden ist;
      o der Sensor (300', 300a') transformatorisch mit dem Zwischenkreis-Filter (207c, 207c') gekoppelt ist; und oder Gleichstromkreis zum Anschließen an einen Hochspannungs-Zwischenkreis eingerichtet ist.

7. Hochspannungs-Zwischenkreis (100, 100') für ein Fahrzeug aufweisend:

   - eine Versorgungsbatterie (101);
   - eine erste Komponente (102a), welche mit einer Arbeitsfrequenz betrieben wird;
   - zumindest eine zweite Komponente (102b, 102c, 102d);
   - zumindest eine Entstörvorrichtung nach einem der Ansprüche 1 - 5; wobei

      o die Versorgungsbatterie, die erste Komponente und die zweite Komponente jeweils mit einem ersten Leiter und einem zweiten Leiter des Hochspannungs-Zwischenkreises verbunden sind;
      o der erste Leiter der zumindest einen zweiten Komponente mit dem ersten Komponentenanschluss (VCc) der Entstörvorrichtung verbunden ist;
      o der zweite Leiter der zumindest einen zweiten Komponente mit dem zweiten Komponentenanschluss (Mc) der Entstörvorrichtung verbunden ist; und
      o der Sensor (300', 300a') der Entstörvorrichtung transformatorisch mit dem zu der zumindest zweiten Komponente gehörenden Teil des ersten Leiters gekoppelt ist.

8. Fahrzeug aufweisend zumindest einen Gegenstand ausgewählt aus:

- der Entstörvorrichtung nach einem der Ansprüche 1 bis 5;
- der Komponente nach Anspruch 6;
- dem Hochspannungs-Zwischenkreis nach Anspruch 7.

**Claims**

1.  Circuit for distortion cancellation (300, 300a) in a DC circuit (100, 100'), which has two conductors (103', 103c, 104', 104c),

    wherein the circuit for distortion cancellation (300, 300a) comprises:

    - a first component connection (VCc) for connecting the circuit for distortion cancellation (300, 300a) to a first conductor (103', 103c) of the DC circuit (100, 100');
    - a second component connection (Mc) for connecting the circuit for distortion cancellation (300, 300a) to a second conductor (104', 104c) of the DC circuit (100, 100');
    - a sensor (300', 300a'), wherein the sensor:

        - is transformer-coupled to a DC circuit (100, 100');
        - is equipped to detect an exceeding of a predetermined limit of a superimposed AC current in the first conductor (103', 103c) of the DC circuit; and
        - is equipped to reduce the AC current in the first conductor of the DC circuit to the predetermined limit by applying a current into the first component connection (VCc);

    wherein the sensor (300', 300a') has a coil (302, L3; L3') for transformer-coupling to the first conductor of the DC circuit in order to form a transformer with the DC circuit (100, 100') having a predetermined coupling factor (k); wherein a first connection of the coil (L3; L3') is connected to the first component connection (VCc), **characterized in that**
    a second connection of the coil (L3; L3') is connected to the first component connection (VCc) via at least one capacitor (303, C3; C3', C4) and via at least one diode ($D_1$, 304, $D_2$, 305; D1', D2', D3, D4);
    wherein a connection of the at least one capacitor (C3; C3', C4) is connected to the second component connection (Mc) via a further diode (D2; D4);
    wherein the anode of the at least one diode ($D_1$, 304, $D_2$, 305; D1', D2', D3, D4) is connected to the cathode of the further diode (D2; D4).

2.  Circuit for distortion cancellation (300, 300a) according to claim 1,
    wherein the first component connection (VCc) and the second component connection (Mc) is designed for connecting to a vehicle component (102a, 102b, 102c, 102d) .

3.  Circuit for distortion cancellation (300, 300a) according to claim 1 or 2,
    whose sensor (300', 300a') is equipped to be coupled to a filter coil (L2, 203c, 204c) and/or to a lead inductance (L2, 203c, 204c) of the DC circuit.

4.  Circuit for distortion cancellation (300, 300a) according to one of claims 1 to 3,
    which is equipped to be coupled to a DC circuit (100, 100') which has a DC voltage of 400 V or 900 V.

5.  Circuit for distortion cancellation (300, 300a) according to one of claims 1 to 4,
    further having: a housing; wherein the housing is designed for fastening to a vehicle.

6.  Component (102a, 102b, 102c, 102d) having:

    - a DC circuit (100, 100') with a first conductor (103', 103c), a second conductor (104', 104c), and a DC link filter (207c, 207c') in the first conductor;
    - a circuit for distortion cancellation (300, 300a) according to one of claims 1-5; wherein

        - the first component connection (VCc) of the circuit for distortion cancellation is connected to the first conductor (103', 103c);
        - the second component connection (Mc) of the circuit for distortion cancellation is connected to the second conductor (104', 104c);
- the sensor (300', 300a') is transformer-coupled to the DC link filter (207c, 207c'); and
- the DC circuit is equipped for connecting to a high-voltage DC link.

7. High-voltage DC link (100, 100') for a vehicle having:

- a supply battery (101);
- a first component (102a) which is operated at an operating frequency;
- at least one second component (102b, 102c, 102d);
- at least one circuit for distortion cancellation according to one of claims 1-5;
wherein
- the supply battery, the first component, and the second component are each connected to a first conductor and to a second conductor of the high-voltage DC link;
- the first conductor of the at least one second component is connected to the first component connection (VCc) of the circuit for distortion cancellation;
- the second conductor of the at least one second component is connected to the second component connection (Mc) of the circuit for distortion cancellation; and
- the sensor (300', 300a') of the circuit for distortion cancellation is transformer-coupled to the part of the first conductor associated with at least the second component.

8. Vehicle having at least one subject matter selected from:

- the circuit for distortion cancellation according to one of claims 1-5;
- the component according to claim 6;
- the high-voltage DC link according to claim 7.


**Revendications**

1. Dispositif d'antiparasitage (300, 300a) pour un circuit à courant continu (100, 100'), lequel comporte deux conducteurs (103', 103c, 104', 104c),

- le dispositif d'antiparasitage (300, 300a) comprenant :
- un premier raccord de composant (VCc), destiné à connecter le dispositif d'antiparasitage (300, 300a) avec un premier conducteur (103', 103c) du circuit à courant continu (100, 100') ;
- un deuxième raccord de composant (Mc), destiné à connecter le dispositif d'antiparasitage (300, 300a) avec un deuxième conducteur (104', 104c) du circuit à courant continu (100, 100') ;
- un capteur (300', 300a'), le capteur :

 - étant susceptible d'être couplé pour former un transformateur avec le circuit à courant continu (100, 100') ;
 - étant configuré pour identifier un dépassement d'une valeur limite prédéfinissable pour une tension alternative superposée dans le premier conducteur (103', 103c) du circuit à courant continu ; et
 - étant configuré pour, en délivrant un courant dans le premier raccord de composant (VCc) réduire la tension alternative dans le premier conducteur du circuit à courant continu à la valeur limite prédéfinissable ;

pour le couplage pour former un transformateur avec le premier conducteur du circuit à courant continu, le capteur (300', 300a') comportant une bobine (302, L3; L3'), pour constituer avec le circuit à courant continu (100, 100') un transformateur assorti d'un facteur de couplage (k) prédéfinissable ;
un premier raccord de la bobine (L3 ; L3') étant connecté avec le premier raccord de composant (VCc), **caractérisé en ce qu'**un deuxième raccord de la bobine (L3 ; L3') est connecté par l'intermédiaire d'au moins un condensateur (303, C3 ; C3', C4) et par l'intermédiaire d'au moins une diode (D$_1$ 304, D$_2$, 305; D1', D2', D3, D4) avec le premier raccord de composant (VCc) ;
un raccord de l'au moins un condensateur (C3 ; C3', C4) étant connecté par l'intermédiaire d'une diode (D2 ; D4) supplémentaire avec le deuxième raccord de composant (Mc) ;
l'anode de l'au moins une diode (D$_1$, 304, D$_2$, 305 ; D1', D2', D3, D4) étant connecté avec la cathode de la diode (D2 ; D4) supplémentaire.

2. Dispositif d'antiparasitage (300, 300a) selon la revendication 1,

<div align="center">15</div>

le premier raccord de composant (VCc) et le deuxième raccord de composant (Mc) étant conçus pour la connexion avec un composant de véhicule (102a, 102b, 102c, 102d).

3. Dispositif d'antiparasitage (300, 300a) selon la revendication 1 ou 2, dont le capteur (300', 300a') est configuré pour être couplé avec une bobine de filtre (L2, 203c, 204c) et / ou une inductance de ligne (L2, 203c, 204c) du circuit à courant continu.

4. Dispositif d'antiparasitage (300, 300a) selon l'une quelconque des revendications 1 à 3, lequel est configuré pour être couplé avec un circuit à courant continu (100, 100') qui présente une tension continue de 400 V ou de 900 V.

5. Dispositif d'antiparasitage (300, 300a) selon l'une quelconque des revendications 1 à 4, comportant par ailleurs : un boîtier ; le boîtier étant conçu pour être fixé sur un véhicule.

6. Composant (102a, 102b, 102c, 102d) comportant :

- un circuit à courant continu (100, 100'), pourvu d'un premier conducteur (103', 103c), d'un deuxième conducteur (104', 104c) et d'un filtre de circuit intermédiaire (207c, 207c') dans le premier conducteur ;
- un dispositif d'antiparasitage (300, 300a) selon l'une quelconque des revendications 1 à 5 ;

- le premier raccord de composant (VCc) du dispositif d'antiparasitage étant connecté avec le premier conducteur (103', 103c) ;
- le deuxième raccord de composant (Mc) du dispositif d'antiparasitage étant connecté avec le deuxième conducteur (104', 104c) ;
- le capteur (300', 300a') étant couplé pour former un transformateur avec le filtre de circuit intermédiaire (207c, 207c') ; et
- le circuit à courant continu étant configuré pour être raccordé sur un circuit intermédiaire haute tension.

7. Circuit intermédiaire haute tension (100, 100') destiné à un véhicule, comportant :

- une batterie d'alimentation (101) ;
- un premier composant (102a), que l'on fait fonctionner à une fréquence de travail ;
- au moins un deuxième composant (102b, 102c, 102d) ;
- au moins un dispositif d'antiparasitage selon l'une quelconque des revendications 1 à 5 ;

- la batterie d'alimentation, le premier composant et le deuxième composant étant connectés chacun avec un premier conducteur et un deuxième conducteurs du circuit intermédiaire haute tension ;
- le premier conducteur de l'au moins un deuxième composant étant connecté avec le premier raccord de composant (VCc) du dispositif d'antiparasitage ;
- le deuxième conducteur de l'au moins un deuxième composant étant connecté avec le deuxième raccord de composant (Mc) du dispositif d'antiparasitage ; et
- le capteur (300', 300a') du dispositif d'antiparasitage étant couplé pour former un transformateur avec la partie du premier conducteur qui fait partie de l'au moins un deuxième composant.

8. Véhicule, comportant au moins un objet, sélectionné parmi :

- le dispositif d'antiparasitage selon l'une quelconque des revendications 1 à 5 ;
- le composant selon la revendication 6 ;
- le circuit intermédiaire haute tension selon la revendication 7.

Fig. 1

Fig. 2

Fig. 3

Fig. 4

Fig. 5a

Fig. 5b

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 2160925 A1

- US 2005141248 A1